# EUROPEAN PATENT SPECIFICATION

(11) **EP 0 804 061 B1**
(45) Date of publication and mention of the grant of the patent: **13.05.2009**
(21) Application number: 96907729.6
(22) Date of filing: 29.03.1996
(51) Int. Cl.: H05K 3/46

(54) **MULTILAYERED PRINTED WIRING BOARD AND ITS MANUFACTURE**
MEHRSCHICHTIGE LEITERPLATTE UND IHRE HERSTELLUNG
CARTE A CIRCUITS IMPRIMES MULTICOUCHE ET SA FABRICATION

(30) Priority: 10.11.1995 JP 31746995
(43) Date of publication of application: 29.10.1997
(60) Divisional application: 06017887.8
(73) Proprietor: IBIDEN CO, LTD., Ogaki-shi, Gifu 503 (JP)
(72) Inventor: YASUE, Toshihiko, Ogaki Gifu 503 (JP); HIRAMATSU, Yasuji, Ogaki Gifu 503 (JP); YANO, Hideki, Gifu 503 (JP); ISHITANI, Yoshifumi, Ibigawa-cho Ibi-gun Gifu 501-06 (JP); KAWAMURA, Yoichiro, Ibi-gun Gifu 501-06 (JP); MURASE, Hideki, Ibi-gun Gifu 501-06 (JP); SUZUKI, Ayumi, Ibi-gun Gifu 501-06 (JP); KAWADE, Masato, Ibi-gun Gifu 501-06 (JP)
(74) Representative: Grünecker, Kinkeldey, Stockmair & Schwanhäusser Anwaltssozietät
(86) International application number: PCT/JP1996/000869
(87) International publication number: WO 1997/017824

(56) References cited:
- EP-A- 0 351 034
- EP-A- 0 625 537
- GB-A- 2 095 916
- JP-A- 2 188 992
- JP-A- 5 007 080
- JP-A- 5 067 881
- JP-A- 5 299 837
- JP-A- 7 030 259
- JP-A- 51 022 065
- JP-A- 58 147 097
- JP-A- 60 062 193
- PATENT ABSTRACTS OF JAPAN vol. 95, no. 11, 26 December 1995 (1995-12-26) & JP 07 202433 A (IBIDEN CO), 4 August 1995 (1995-08-04)
- PATENT ABSTRACTS OF JAPAN vol. 95, no. 10, 30 November 1995 (1995-11-30) & JP 07 193373 A (IBIDEN CO), 28 July 1995 (1995-07-28)
- PATENT ABSTRACTS OF JAPAN vol. 18, no. 673 (E-1647), 19 December 1994 (1994-12-19) & JP 06 268380 A (IBIDEN CO), 22 September 1994 (1994-09-22)
- PATENT ABSTRACTS OF JAPAN vol. 95, no. 11, 26 December 1995 (1995-12-26) & JP 07 226593 A (HITACHI CHEM CO), 22 August 1995 (1995-08-22)
- PATENT ABSTRACTS OF JAPAN vol. 99, no. 10, 30 November 1995 (1995-11-30) & JP 07 170073 A (TOAGOSEI CO), 4 July 1995 (1995-07-04)
- PATENT ABSTRACTS OF JAPAN vol. 95, no. 06, 31 July 1995 (1995-07-31) & JP 07 066560 A (TOAGOSEI CO), 10 March 1995 (1995-03-10)
- PATENT ABSTRACTS OF JAPAN vol. 95, no. 11, 26 December 1995 (1995-12-26) & JP 07 226583 A (HITACHI CHEM CO), 22 August 1995 (1995-08-22)

## Description

### TECHNICAL FIELD

This invention relates to a multilayer printed circuit board and a method of producing a multilayer printed circuit board, and more particularly it proposes a structure of a resin insulating layer suitable for the provision of a multilayer printed circuit board having an improved interlaminar insulation property and a method of producing the same.

### BACKGROUND ART

As the multilayer printed circuit board, there is a build-up multilayer printed circuit board in which a conductor circuit and a resin insulating layer are alternately built-up and an inner circuit layer and an outer circuit layer are electrically connected to each other through viaholes or the like. This build-up multilayer printed circuit board is generally manufactured by a method wherein a layer of the conductor circuit is formed in a position closest to a substrate by a subtractive process and then a plurality of conductor circuit layers are laminated on the conductor circuit layer by an additive process.

The subtractive process is a method of forming the conductor circuit by subjecting a surface of a copper lined laminate to an etching treatment and can cheaply form the conductor circuit layer having a high reliability.

The additive process is a method wherein an adhesive for electroless plating is applied onto a substrate such as glass epoxy or the like to form a resin insulating layer and then the resin insulating layer is roughened and a plating resist is formed on the roughened surface and then a metal for conductor circuit is applied thereto by electroless plating. According to this method, the conductor circuit is formed on the roughened resin insulating layer through the plating or the like, so that the excellent adhesion property therebetween can be ensured and hence there can be manufactured a printed circuit board in which the conductor circuit hardly peels from the resin insulating layer.

In JP 07170073 A**,** Patent Abstracts of Japan vol. 99, no. 10 (1995-11-30), a method to manufacture a multilayer wiring board provided with a blind viahole by a hot roller method is described. A resin layer is formed on a lower conductor circuit layer formed on a substrate such that the resin layer is present between the conductor circuit pattern parts. A second resin layer formed on the roughened surface of a copper foil is laminated thereon.

Patent document EP-A-0351 034 describes a process for producing printed wiring boards using a composite film. The composite film comprises a resin insulating layer containing epoxy resin and a synthetic rubber and an adhesive layer which is laminated on both sides of the substrate provided with a conductor layer.

In JP 07 202433 A**,** Patent Abstracts of Japan vol. 95, no. 11, (1995 -12 - 26), a method of manufacturing a multilayer printed circuit board is described including immersing the inner layer substrate with a lower conductor circuit layer into a liquid filler to fill the through-hole therewith followed by laminating an adhesive dry film thereon to form a composite resin insulating layer to thus enhance smoothness.

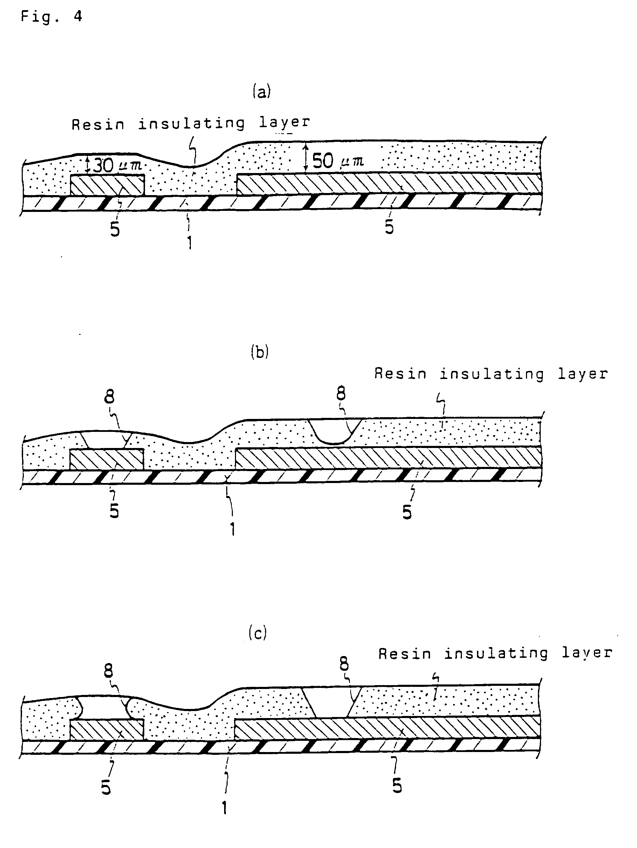

In the multilayer printed circuit board, when the innermost conductor circuit is formed by the subtractive process, concave portion is caused between the conductor circuits formed by the etching treatment. Therefore, when the resin insulating layer is formed on the wiring substrate having the concave portion between the conductor circuits, as shown in Fig. 4(a), the surface of the resin insulating layer becomes uneven and hence there is caused a problem that the viahole shape formed in the resin insulating layer and junction pad are deformed to cause poor mounting.

Concretely, the resin insulating layer formed in a large area portion of the conductor circuit becomes thicker as compared with the resin insulating layer formed in a small area portion of the conductor circuit. As a result, the exposure and development conditions of the viahole vary in accordance with the thickness of the resin insulating layer, so that
①. When the exposure and development conditions are matched with the thin portion of the resin insulating layer, a developing residue is created in the viahole formed in the thick portion of the resin insulating layer to close the opening of the viahole and hence the connection to a wiring layer arranged on the upper layer becomes incomplete (see Fig. 4(b)).
②. When the exposure and development conditions are matched with the thick portion of the resin insulating layer, the insulating material is peeled from the vicinity of the viahole formed in the thin portion of the resin insulating layer, which results in the poor insulation (see Fig. 4(c)).

On the other hand, the resin insulating layer being inevitable in the above additive process is generally formed by simply applying one kind of the resin composition. However, as the printed circuit board is recently used in various fields, it is very difficult to form the resin insulating layer so as to exhibit excellent application adaptability in all fields. Lately, the resin insulating layer constituting the printed circuit board tends to become thinner in accordance with the high performance and high densification of electric parts, which is difficult to ensure the insulating property between the conductor layer and another conductor layer and hence results in the lowering of reliability in the multilayer printed circuit board.

Furthermore, the surface of the resin insulating layer is roughened by using an acid or an oxidizing agent and dissolving and removing particles of heat-resistant resin soluble in the oxidizing agent or the like, which are dispersed in heat-resistant resin hardly soluble in the oxidizing agent or the like. However, if aggregation or the like is caused in the heat-resistant resin particles to be dissolved and removed, the depth of the roughened layer is not constant. Particularly, when the resin insulating layer is thin, the depth of the roughened layer may arrive at the thickness of the resin insulating layer and hence the interlaminar insulation property naturally required in the resin insulating layer considerably lowers.

It is a main object of the invention to provide a new structure of a resin insulating layer capable of providing a multilayer printed circuit board having an excellent interlaminar insulation property without lowering the peel strength even if the thickness of the resin insulating layer is thin.

It is another object of the invention to provide a multilayer printed circuit board having an excellent resolution capable of conducting exposure and development treatments under same conditions without forming unevenness on the surface even if an innermost layer of conductor circuits is formed by an etching treatment through the subtractive process as well as a method of producing the same.

It is the other object of the invention to provide a multilayer printed circuit board having excellent resolution, interlaminar insulation property and resistance to cool and heat shocks.

### DISCLOSURE OF THE INVENTION

The inventors have made various studies in order to achieve the above objects. As a result, the inventors have found that it is effective to achieve the above objects when the resin insulating layer is constructed with a composite film comprising at least two layers of an adhesive layer for electroless plating contributing to improve an adhesion strength to conductor and an insulating layer contributing to improve an interlaminar insulation property, and when a resin smoothening a surface of a substrate is filled between conductor circuits formed by the subtractive process and subjected to a polishing, if necessary.

The invention is based on these knowledges and pertains to a multilayer printed circuit board comprising the features of claim 1 and to a method of producing the multilayer printed circuit board comprising the steps set out in claim 6.

The multilayer printed circuit board of the present invention comprises: an upper conductor circuit layer, a lower conductor circuit layer and a resin insulating layer electrically insulating both the conductor circuit layers, wherein said lower conductor circuit layer is formed by etching a substrate provided with a conductor layer to remove a conductor useless portion therefrom, and a filling resin is filled in a concave portion formed by removing the conductor useless portion so that the surface of the resin is same as the surface of the lower conductor circuit layer.

The resin filled in the concave portion formed by removing the conductor useless portion contains ceramic particles. The resin insulating layer is comprised of a composite layer consisting of an insulating layer made from a heat-resistant resin hardly soluble in acid or an oxidizing agent as a lower layer and an adhesive layer for electroless plating made from a heat-resistant resin as an upper layer, and said upper conductor circuit layer is formed on said adhesive layer constituting the upper layer of said resin insulating layer.

It is preferable that the resin filled in the concave portion formed by removing the conductor useless portion is a cured product of non-solvent resin.

It is desirable that particles of a heat-resistant resin soluble in the acid or oxidizing agent and having an average particle size of 0.1-0.6 µm are dispersed in the insulating layer comprised of a composite layer as described above. A method of producing a multilayer printed circuit board of the present invention comprising an upper conductor circuit layer, a lower conductor circuit layer and a resin insulating layer electrically insulating both the conductor circuit layers, comprises the following steps (a) - (e):
(a) a step of forming said lower conductor circuit layer by etching a substrate provided with a conductor layer to remove a conductor useless portion therefrom;
(b) a step of applying a resin containing ceramic particles to the substrate having a concave portion formed by removing the conductor useless portion and then curing the resin;
(c) a step of polishing the cured resin of the step (b) till the lower conductor circuit layer is exposed;
(d) a step of forming said resin insulating layer. wherein said resin insulating layer is a composite layer consisting of an insulating layer made from a heat-resistant resin hardly soluable in acid or an oxidizing agent as a lower layer and an adhesive layer for electroless plating made from a heat-resistant resin as an upper layer;
(e) a step of forming said upper conductor circuit layer on said resin insulating layer.

It is desirable that particles of a heat-resistant resin soluble in the acid or oxidizing agent and having an average particle size of 0.1-0.6 µm are dispersed in the insulating layer formed of a composite layer as described above.

### BRIEF DESCRIPTION OF THE DRAWINGS

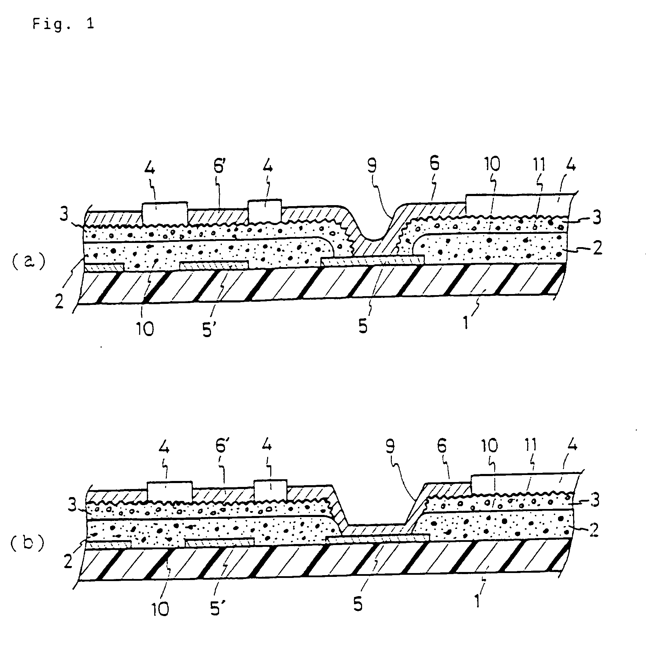

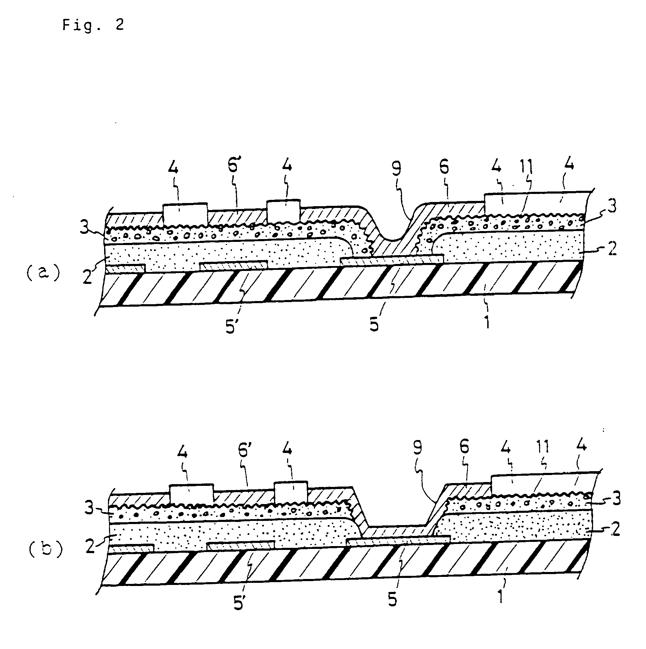

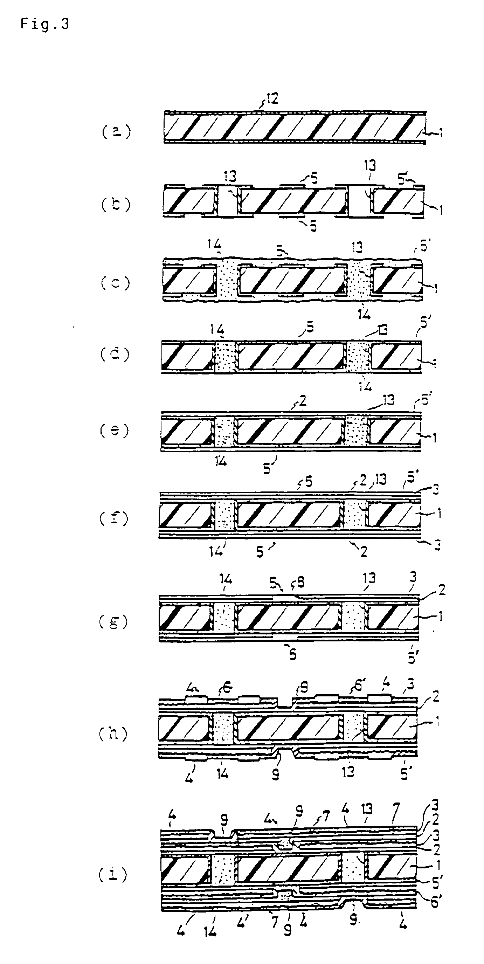

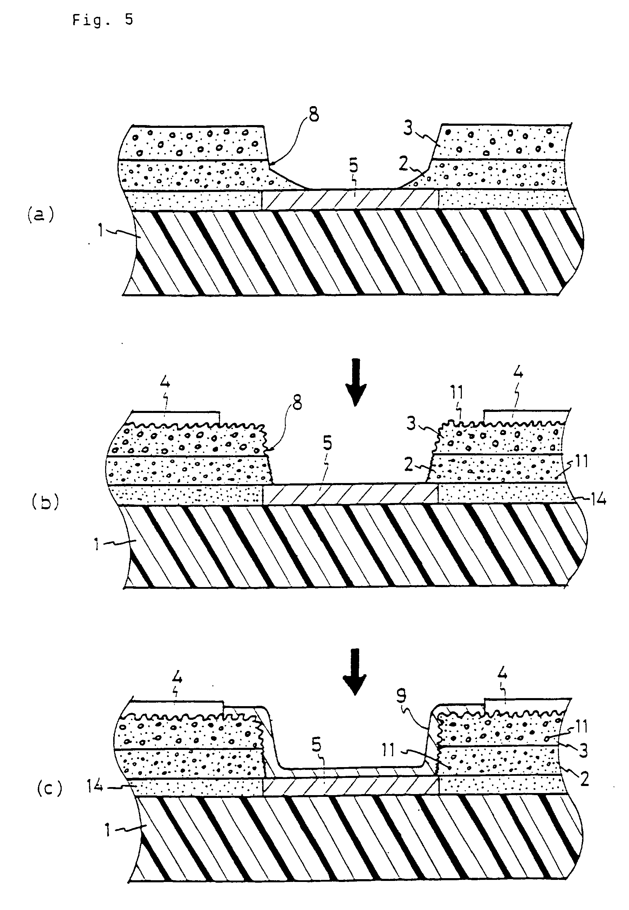

Fig. 1 is a schematically sectional view illustrating an example of a resin insulating layer in a known multilayer printed circuit board. Fig. 2 is a schematically sectional view illustrating another example of a resin insulating layer in a known multilayer printed circuit board. Fig. 3 is a flow chart showing the production of the multilayer printed circuit board according to the invention in Example 10. Fig. 4 is a partial section view illustrating a forming state of the resin insulating layer, wherein (a) shows a case that the thickness of the insulating layer becomes thick as the conductor area becomes large, (b) shows a state of an opening for viahole when the exposure and development conditions are matched with a thin portion of the resin insulating layer, and (c) shows a state of an opening for viahole when the exposure and development conditions are matched with a thick portion of the resin insulating layer. Fig. 5 is a diagrammatic view illustrating a step of forming the viahole when finer resin particles soluble in an acid or oxidizing agent are dispersed in an insulating layer as a lower layer.

Here, numeral 1 is a substrate, 2 an insulating layer, 3 an adhesive layer, 4 a plating resist, 5, 6 and 7 plated films (conductor layer, conductor pattern), 5' and 6' plated films requiring interlaminar insulation (conductor layer, conductor pattern), 8 an opening for viahole, 9 a viahole (BVH), 10 an organic resin filler, 11 a heat-resistant resin particle, 12 a copper foil, 13 a through-hole, and 14 a filling resin.

### BEST MODE FOR CARRYING OUT THE INVENTION

A first feature of the invention lies in a point that the resin insulating layer is rendered into a composite of a lower layer and an upper layer and the lower layer is constructed with an unroughenable insulating layer made from a heat-resistant resin hardly soluble in the acid or oxidizing agent, preferably an insulating layer made from a heat-resistant resin containing an organic resin filler hardly soluble in the acid or oxidizing agent and the upper layer is constructed with a roughenable adhesive layer for electroless plating made from a heat-resistant resin, preferably an adhesive layer made from a heat-resistant resin containing heat-resistant resin particles soluble in the acid or oxidizing agent (see Fig. 1 and Fig. 2).

According to such a resin insulating layer, the lower layer is the unroughenable insulating layer made from the heat-resistant resin hardly soluble in the acid or oxidizing agent, preferably the insulating layer made from the heat-resistant resin containing an organic resin filler hardly soluble in the acid or oxidizing agent, so that even when the thickness of the resin insulating layer is thin, the roughening does not arrive at the lower layer due to the promotion thereof and hence the improvement of the interlaminar insulation property of the printed circuit board can be improved. On the other hand, in the resin insulating layer according to the invention, the upper layer is the roughenable adhesive layer for electroless plating made from the heat-resistant resin, preferably the roughenable adhesive layer made from the heat-resistant resin containing heat-resistant resin particles soluble in the acid or oxidizing agent, so that clear anchors are formed by roughening and hence a high conductor adhesion density (peel strength) can be obtained.

Moreover, the heat-resistant resin particles soluble in the acid or oxidizing agent constituting the adhesive layer may take various shapes such as particulate shape, hollow shape, broken piece and the like. Preferably, they are selected from ① particles having an average particle size of not more than 10 µm, ② aggregate particle having an average particle size of 2-10 µm obtained by aggregating heat-resistant resin powder having an average particle size of not more than 2 µm, ③ mixture of heat-resistant resin powder having an average particle size of 2-10 µm and heat-resistant resin powder having an average particle size of not more than 2 µm, and ④ false particles obtained by adhering at least one of heat-resistant resin powder having an average particle size of not more than 2 µm and inorganic powder having an average particle size of not more than 2 µm to surfaces of heat-resistant resin powder having an average particle size of 2-10 µm. When the average particle size exceeds 10 µm, the anchor becomes deeper and hence so-called fine pattern of not more than 100 µm can not be formed, while when the average particle size is less than 2 µm, clear anchor can not be formed. Among the above ①-④, the resin particles ②-④ are particularly desirable. Because they can form complicated anchors and improve the peel strength.

The compounding amount of the heat-resistant resin particles is desirable to be 5-100 per 100 of resin solid content of the heat-resistant resin matrix on a weight ratio. When the weight ratio is less than 5, the clear anchor can not be formed, while when it exceeds 100, the kneading is difficult and the amount of the heat-resistant resin matrix is relatively decreased to lower the strength of the adhesive layer.

Moreover, the anchor recess formed on the surface of the adhesive layer is desirable to have an average depth of not more than 15 µm, whereby the conductor pattern can be rendered into a fine pattern of not more than L/S = 50/50 µm.

On the other hand, in the resin insulating layer of the above structure according to the invention, the insulating layer of the lower layer is possible to be made from only the heat-resistant resin without using the organic resin filler. In this case, the developing residue created in the development can be suppressed and the rejection rate can be decreased.

And also, it is favorable to include the thermoplastic resin in the insulating layer constituting the resin insulating layer according to the invention because the cracking hardly occurs in the adhesive layer or viahole portion owing to the flexibility inherent to the thermoplastic resin.

The insulating layer containing the thermoplastic resin is particularly desirable to be made from a resin composite of a thermosetting resin (a part of thermosetting group may be substituted with a photosensitive group) and a thermoplastic resin. Because, the acid resistance and the resistance to oxidizing agent are ensured by the rigid skeleton of the thermosetting resin and the toughness is ensured by the flexibility of the thermoplastic resin, whereby there can be obtained a circuit board strong to heat cycle or the like. As the thermosetting resin constituting the resin composite, use may be made of phenolic resin, amino resin such as melamine resin or urea resin, epoxy resin, epoxy-modified polyimide resin, unsaturated polyester resin, polyimide resin, urethane resin, diallylphthalate resin and the like. Particularly, novolac type epoxy resin such as phenol novolac, cresol novolac or the like is preferable as the epoxy resin because it has a rigid skeleton through the arrangement of benzene rings and is excellent in the resistance to oxidizing agent and the acid resistance. As the thermoplastic resin, use may be made of polyether sulphone, polysulphone, phenoxy resin, polyether imide, polystyrene, polyethylene, polyarylate, polyamidoimide, polyphenylene sulfide, polyether ether ketone, polyoxybenzonate, polyvinyl chloride, polyvinyl acetate, polyacetal, polycarbonate and the like. Particularly, polyether sulphone is favorable in view of toughness and compatibility with epoxy resin.

As mentioned above, the resin insulating layer according to the invention is the structure of the layer composite consisting of the adhesive layer as an upper layer and the insulating layer as a lower layer, in which these layers allot function of bearing the adhesion of conductor and function of bearing the insulation between conductors to each, so that even if the resin insulating layer is thin, there can be stably provided printed circuit boards simultaneously satisfying excellent peel strength and interlaminar insulation property.

In the resin insulating layer according to the invention, it is preferable that the thickness of the insulating layer as the lower layer is 10-100 µm. When the thickness of the insulating layer is less than 10 µm, the function as the resin insulating layer is apt to be insufficient, while when the thickness of the insulating layer exceeds 100 µm, the resin insulating layer is formed at a thickness larger than the required level and is uneconomical.

The adhesive layer as an upper layer is preferable to have a thickness of 10-50 µm. Because, the roughened surface having a sufficient thickness can be formed when the thickness of the adhesive layer is not less than 10 µm, and the function as the adhesive can effectively be developed when the thickness of the adhesive layer is within a range of 10-50 µm.

Furthermore, the amount of the organic resin filler filled in the insulating layer as the lower layer is favorable to be 10-100 parts by volume based on 100 parts by volume of the heat-resistant resin. Because, when the amount is within the above range, the viscosity in the application can be maintained to a preferable range and the resin layer having a uniform thickness can easily be formed.

The organic resin filler is heat-resistant resin particles hardly soluble in the acid or oxidizing agent, which are preferable to have a maximum particle size corresponding to not more than 8/10 of the thickness of the insulating layer and an average particle size corresponding to not more than 1/2 of the thickness of the insulating layer, and are more favorable to have a maximum particle size corresponding to not more than 1/2 of the thickness of the insulating layer and an average particle size corresponding to not more than 1/3 of the thickness of the insulating layer. Because, when the maximum particle size exceeds 8/10 of the thickness of the insulating layer, the cracks dividing the insulating layer are apt to be caused.

When the heat-resistant resin particle hardly soluble in the acid or oxidizing agent is a heat-resistant resin particle hardly soluble in the acid, epoxy resin can be used (the use of imidazole curing agent, acid anhydride cured product or the like). In case of heat-resistant resin particle hardly soluble in the oxidizing agent, there can be used resin particles of benzoguanamine resin, styrene resin, divinylbenzene resin, polyimide resin or the like.

Moreover, it is considered that inorganic filler is used instead of the organic resin filler. However, when the inorganic filler is used, the reflection of the exposed light may be diffused by the inorganic filler, so that there is undesirably caused a new problem that the resolution of the resin insulating layer is lowered in the formation of viahole (BVH).

An important feature of the invention lies in a point that when a certain acid or oxidizing agent is used, the lower layer is formed by dispersing the heat-resistant resin particles insoluble in the acid or oxidizing agent into the hardly soluble heat-resistant resin and the upper layer is formed by dispersing the heat-resistant resin particles soluble in the acid or oxidizing agent into the hardly soluble heat-resistant resin. Particularly, when the heat-resistant resin particles filled in the lower layer and upper layer have a thermal expansion coefficient lower than that of the heat-resistant resin as a substrate, the resistance to cooling-heating shock in the printed circuit board can be improved.

In the invention, there is proposed the insulating layer as a lower layer having such a structure that heat-resistant resin particles soluble in acid or oxidizing agent and having an average particle size of 0.1-0.6 µm are dispersed into the heat-resistant resin hardly soluble in the acid or oxidizing agent as another method of preventing electric conduction between the upper conductor circuit layer and lower conductor circuit layer due to the excessive roughening of the resin insulating layer.

According to such a structure, the fine resin particles dispersed in the resin matrix and having an average particle size of 0.1-0.6 µm do not communicate with each other through the roughening treatment and also poor insulation is not caused even in the roughening. Furthermore, the fine resin particles are less in the diffused reflection of the exposed light and hence are excellent in the resolution. And also, when the interlaminar insulating layer (the adhesive layer and the insulating layer) is subjected to a light exposure and development, there may be created the poor development (development residue) of the interlaminar insulating layer resulted from poor adhesion of the developing solution (see Fig. 5(a)). In this case, when fine resin particles dissolving in the acid or oxidizing agent are existent in the insulating layer, if the poor development is caused, these fine resin particles are dissolved at the step of the roughening treatment with the acid or oxidizing agent and hence the resin matrix may be dissolved and broken to remove the remaining resin (see Fig. 5(b)). On the thus formed side wall of the opening for viahole are formed fine anchors in addition to the anchor on the adhesive layer of the upper layer when the fine resin particles dissolving in the acid or oxidizing agent are dispersed in the insulating layer of the lower layer, so that the adhesion strength of the viahole is more improved (see Fig. 5(c)). However, when the fine resin particles have an average particle size of less than 0.1 µm, the anchor effect or the effect of removing the development residue is not caused, while when the average particle size exceeds 0.6 µm, the excessive roughening may be created to cause the electric conduction between the upper and lower conductor circuit layers. Therefore, the average particle size of the resin particles is desirable to be 0.1-0.6 µm.

In the resin insulating layer according to the invention, the heat-resistant resin used in the production of the printed circuit board is constituted by properly compounding a thermosetting resin, a thermosetting resin partly provided with a photosensitivity, a photosensitive resin, a resin composite of thermosetting resin or photosensitive resin and thermoplastic resin, a photoinitiator, a photoinitiator promoter, a curing agent and the like and added with heat-resistant resin fine particles, if necessary.
(1) As the thermosetting resin, there is preferably used at least one resin selected from phenolic resin, amino resin such as melamine resin or urea resin, epoxy resin, epoxy-modified polyimide resin, unsaturated polyester resin, polyimide resin, urethane resin, diallylphthalate resin, allyl resin and urea resin.
(2) As the thermosetting resin partly provided with a photosensitivity, there is preferably used a partly acrylated phenol novolac type epoxy resin or cresol novolac type epoxy resin. Moreover, the acrylation is carried out by reacting the epoxy resin with acrylic acid, methacrylic acid or the like. The acrylation ratio means a percentage of a portion of the epoxy group reacted with acrylic acid or methacrylic acid and may easily be changed, if necessary.
(3) As the photosensitive resin, there are preferably used the conventionally known single-functional or multifunctional photosensitive resins such as acrylic resin, tripropylene glycol diacrylate, trimethylol propane triacrylate, pentaerythritol triacrylate, polyethylene glycol diacrylate, epoxy acrylate and the like.
(4) As the thermoplastic resin, there is preferably used at least one resin selected from polyether sulphone, polysulphone, phenoxy resin, polyether imide, polystyrene, polyethylene, polyarylate, polyamideimide, polyphenylene sulfide, polyether ether ketone, polyoxybenzonate, polyvinyl chloride, polyvinyl acetate, polyacetal and polycarbonate.
(5) As the resin composite of thermosetting resin or photosensitive resin and thermoplastic resin, PES-modified epoxy resin, PES-modified acrylic resin and the like are preferably used.
(6) As the photoinitiator, there is preferably used at least one of ① intramolecular bond cleavage type compound such as benzoisobutyl ether, benzyldimethyl ketal, diethoxyacetophenone, acyloxym ester, chlorinated acetophenone, hydroxyacetophenone or the like, and ② intermolecular hydrogen drawing type compound such as benzophenone, Michlar ketone, dibenzosuberone, 2-ethyl anthraquinone, isobutyl thioxane or the like.
(7) As the photoinitiator promotor, there is preferably used at least one of triethanol amine, methyldiethanol amine, triisopropanol amine, Michlar ketone, 4,4-diethylamino benzophenone, 2-dimethylaminoethyl benzoic acid, 4-dimethylamino benzoic acid ester, (n-butoxy)ethyl 4-dimethylamino benzoate, isoamyl 4-dimethylamino benzoate, 2-ethylhexyl 4-dimethylamino benzoate, polymerizable tertiary amine and the like.
(8) As the curing agent, DICY, amine curing agent, acid anhydride, imidazole curing agent and the like are favorably used in case of epoxy resin and its photosensitized product. Particularly, it is preferably to contain 2-10 wt% of the imidazole curing agent as a solid content. When the content of the imidazole curing agent exceeds 10 wt%, the resin is too cured and becomes brittle, while when it is less than 2 wt%, the curing of the resin is insufficient and the satisfactory resin strength is not obtained. As the curing agent for the other thermosetting resin, there are used the conventionally known ones.

As the heat-resistant resin used in the resin insulating layer according to the invention, the resin containing no solvent can be used as it is, but the resin dissolved in the solvent can advantageously be used in case of particularly producing the sheet-like resin insulating layer because the adjustment of the viscosity is easy and the resin particles can uniformly be dispersed and the application is easy to the base film.

As the solvent dissolving the heat-resistant resin, mention may be made of usual solvents such as methylethyl ketone, methylcellosolve, ethylcellosolve, butylcellosolve, butylcellosolve acetate, butyl carbitol, butylcellulose, tetraline, dimethylformamide, normalmethyl pyrolidone and the like.

Moreover, the heat-resistant resin may properly be compounded with additives such as coloring matter (pigment), leveling agent, anti-foaming agent, ultraviolet ray absorbing agent, flame retarder and the like, or other filler.

A second feature of the invention lies in a point that a resin is filled in a concave portion of conductor useless part removed from the conductor circuit as a lower layer formed by so-called subtractive process of etching the substrate provided with the conductor layer to remove the conductor useless part at the same level as the surface of the conductor circuit.

According to the structure that the conductor circuit is formed as a lowest layer through the subtractive process and the resin is filled in the concave portion of the removed conductor layer, the surface of the substrate provided with the conductor circuit becomes smooth, and the resin insulating layer having a uniform thickness can be formed on such a substrate by the application. As a result, the thickness of the resin insulating layer becomes uniform and the exposure and development conditions can be unified and hence the peeling of the resin insulating layer by the poor development or excessive development is not created. Therefore, when plural conductor circuit layers are laminated thereon through the additive process, each conductor layer becomes smooth and the shape of the viahole is not distorted and hence the multilayer printed circuit board having excellent connection reliability and mounting reliability can stably be provided.

In such a structure according to the invention, the resin filled in the concave portion of the conductor useless part removed is desirable to be a non-solvent resin. Because, the durability is improved without causing the peeling from the resin insulating layer by gradually evaporating solvent through heat from an electronic part mounted.

Further, in the structure according to the invention, the resin filled in the concave portion of the conductor useless part removed contains a ceramic filler. Because, when it contains the ceramic filler, the curing shrinkage is small and the warping of the substrate is small. Furthermore, the thermal expansion coefficient is small and the resistance to heat cycle is improved. Moreover, the water absorbing ratio is small and the resistance to base and the insulation property are improved.

As the filling resin, there are preferably used epoxy resins (molecular weight: about 150-180) of bisphenol A-type and bisphenol F-type. Because they are soft and are relatively easy in the polishing.

As the ceramic filler, silica, alumina, zirconia and the like are favorably used. The particle size of the ceramic filler may be about 0.5-2.0 µm. When the particle size is too fine, the viscosity of the filling resin is too high and the application is difficult, while when it becomes too rough, the smoothness is lost.

The multilayer printed circuit board according to the invention is a multilayer printed circuit board comprising upper and lower layers of conductor circuit and a resin insulating layer electrically insulating therebetween, wherein the conductor circuit of the lower layer is formed by subjecting a substrate provided with a conductor layer to an etching treatment to remove a conductor useless portion, and a concave portion formed by the removal of the conductor useless portion is filled with a resin so as to be the same plane as the surface of the conductor circuit, and the resin insulating layer is constituted with a composite layer comprised of an insulating layer made from a heat-resistant resin hardly soluble in acid or oxidizing agent as a lower layer and an adhesive layer for electroless plating made from a heat-resistant resin as an upper layer, and the conductor circuit of the upper layer is formed on the adhesive layer constituting the upper layer of the resin insulating layer.

On the conductor circuit formed on the substrate through the subtractive process are successively formed the insulating layer and the adhesive layer to form a the resin insulating layer of the two layers, which is simultaneously cured (exposure treatment) and developed for the formation of an opening for viahole. Therefore, if the surface of the substrate provided with the conductor circuit of the lower layer is not smooth, there is caused an unevenness at the boundary face between the insulating layer as the lower layer and the adhesive layer as the upper layer. In this case, there is caused no problem under the usual service condition, but when the printed circuit board is used under conditions of high temperature, high humidity and the like, the resin absorbs water or expands through heat and hence stress concentration may be caused at the boundary face between the insulating layer as the lower layer and the adhesive layer for electroless plating as the upper layer to create the peeling.

In the multilayer printed circuit board of the above structure according to the invention, however, the surface of the substrate provided with the conductor circuit of the lower layer is smoothened by the filling resin, so that the peeling of the insulating layer and the adhesive layer through the heat expansion or water absorption as mentioned above can completely be prevented.

Further, in the multilayer printed circuit board of the above structure according to the invention, the insulating layer as the lower layer can be rendered into a structure that heat-resistant resin particles soluble in acid or oxidizing agent and having an average particle size of 0.1-0.6 µm are dispersed in the heat-resistant resin hardly soluble in acid or oxidizing agent. According to this structure, the fine resin particles dispersed in the resin matrix and having an average particle size of 0.1-0.6 µm do not communicate with each other through the roughening treatment as previously mentioned or do not cause the poor insulation even if they are roughened. Furthermore, the development residue can be removed without lowering the resolution of the resin insulating layer and hence the adhesion property to the viahole can be improved.

The method of producing the multilayer printed circuit board according to the invention is characterized by comprising the following steps (a) - (e) in the production of the multilayer printed circuit board electrically insulating the conductor circuits of the upper and lower layers through the resin insulating layer.
(a) step of forming the conductor circuit of the lower layer by etching the substrate provided with the conductor layer to remove the conductor useless portion.
(b) step of applying a resin containing ceramic particles to the substrate having the concave portion formed by the removal of the conductor useless portion and thereafter curing the resin.
(c) step of polishing the resin cured in the step of the item (b) until the conductor circuit of the lower layer is exposed.
(d) step of forming the resin insulating layer.
(e) step of forming the conductor circuit of the upper layer on the resin insulating layer.

An embodiment of the production method of the multilayer printed circuit board according to the invention will concretely be described below.
(1) At first, the conductor circuit of the lower layer is formed on the substrate by subjecting the substrate provided with the conductor layer to an etching treatment according to the step (a).
   The etching treatment of the substrate is carried out, for example, by subjecting a copper lined laminate to light exposure and development to form a photosensitive etching resist and immersing in an etching solution such as copper chloride to remove the useless portion of the conductor layer and leave only a necessary conductor circuit portion.
(2) The resin is applied to the substrate having the concave portion through the removal of the conductor useless portion obtained in the step (a) and cured to fill the resin in the concave portion, and further the surface of the filling resin is polished so as to be the same plane as the surface of the conductor circuit until the conductor circuit of the lower layer is exposed.

As the resin filling in the concave portion, the use of non-solvent resin is desirable. Because, when using the resin containing the solvent, as the resin insulating layer is applied and dried under heating, the solvent is evaporated from the filling resin filled for the smoothening to cause the peeling between the filling resin and the resin insulating layer. As the filling resin, there is preferably used bisphenol A-type or bisphenol F-type epoxy resin (molecular weight: about 150-180) because it is soft and relatively easy in the polishing.

Further, the filling resin contains ceramic filler such as silica, alumina, zirconia or the like. Because, the presence of the ceramic filler makes the cure-shrinking small and prevents the warping of the substrate. Desirably, the ceramic filler having a particle size of about 0.5-2.0 µm is used. When the particle size is too fine, the viscosity of the filling resin becomes higher and the application thereof is difficult, while when it is too rough, the smoothness is lost.

The polishing of the filling resin is desirable to be carried out at a state of not completely curing the resin. That is, the filling resin is desirable to be cured at a polishable state (60-80% of all functional groups is cured) but at a state of being not completely cured because it is soft and easy in the polishing.

Moreover, the polishing of the filling resin can be carried out by a belt sander method, a buff polishing method or the like.
(3) The resin insulating layer is formed on the surface of the substrate filling the resin in the concave portion between the conductor circuits (see the step (d)).

Since the resin insulating layer is formed on the surface of the substrate treated through the steps (a) - (c), the thickness is uniform and hence an opening for viahole can be formed with a high dimensional accuracy. As a result, the poor insulation due to the overetching, poor shape or the like is not caused in the viahole to be formed through the additive process, and also the surface of the upper conductor circuit layer becomes smooth and the connection reliability and mounting reliability are excellent.

In the invention, the resin insulating layer is a composite layer comprised of an insulating layer made from a heat-resistant resin hardly soluble in acid or oxidizing agent as a lower layer and an adhesive layer for electroless plating made from a heat-resistant resin as an upper layer. In this case, the curing of the resin insulating layer forming the opening for the viahole is carried out by simultaneously curing the insulating material and the adhesive. In this point, according to the invention, the surface of the lower conductor circuit layer is smoothened by the filling resin as previously mentioned, whereby the peeling of the adhesive layer and the insulating layer in the cure-shrinking can be prevented. Here, the heat-resistant resin constituting the resin insulating layer is constructed by properly compounding a thermosetting resin, a thermosetting resin partly imparting the photosensitivity, a photosensitive resin, a resin composite of thermosetting resin or photosensitive resin and thermoplastic resin, a photoinitiator, a photoinitiator promoter, a curing agent and the like, and if necessary, adding heat-resistant resin particles.

In the production method of the multilayer printed circuit board according to the invention, the insulating layer as the lower layer can be rendered into a structure that heat-resistant resin particles soluble in acid or oxidizing agent and having an average particle size of 0.1-0.6 µm are dispersed in the heat-resistant resin hardly soluble in acid or oxidizing agent. According to this structure, the fine resin particles dispersed in the resin matrix and having an average particle size of 0.1-0.6 µm do not communicate with each other through the roughening treatment as previously mentioned or do not cause the poor insulation even if they are roughened. Furthermore, the development residue can be removed without lowering the resolution of the resin insulating layer and hence the adhesion property to the viahole can be improved.

Particularly, the formation of the opening for the viahole in the resin insulating layer (composite layer) made from the photosensitized heat-resistant resin is carried out, for example, by the following method.
①. The insulating material is applied onto the substrate provided with the conductor circuit by means of a roll coater or the like, dried, exposed and developed to obtain the insulating layer provided with the opening for the viahole (BHV). Then, the adhesive for electroless plating is applied onto the insulating layer by means of a roll coater or the like, dried, exposed and developed to obtain the adhesive layer provided with the smaller size opening for BVH at the same position as the opening for BVH in the insulating layer. Next, these layers are simultaneously photocured and thermoset to form the opening for the viahole in the resin insulating layer constituted with the composite layer consisting of the insulating layer and the adhesive layer.
②. The insulating material is applied onto the substrate provided with the conductor circuit by means of a roll coater and dried to obtain the insulating layer at B-stage state. Then, the adhesive for electroless plating is applied onto the insulating layer by means of a roll coater and dried to obtain the adhesive layer at B-stage state. Thereafter, these layers are simultaneously exposed and developed to form the opening for the viahole.

As the method of forming the resin insulating layer on the substrate, a method of sticking a resin film formed by rendering the material for the layer into a film shape or a prepreg formed by impregnating the material for the layer in fibers can be adopted in addition to the above application method.
(4) Then, the surface of the rein insulating layer formed in the above item (3) is roughened according to usual manner using acid or oxidizing agent and a catalyst is applied and fixed to the roughened surface of the resin insulating layer. Next, if necessary, a resist printed into a given pattern is formed, and the catalyst is activated by an acid treatment and thereafter the electroless plating is conducted to form the conductor circuit of the upper layer. Further, the insulating material, adhesive and the like are applied onto the upper conductor circuit layer to gradually build up a subsequent layer, whereby the desired multilayer printed circuit board is obtained.

The roughening of the resin insulating layer can be carried out by immersing the substrate provided with the resin insulating layer in a solution of the oxidizing agent or the like, or by spraying the solution of the oxidizing agent or the like onto the surface of the resin insulating layer.

As the acid roughening the resin insulating layer, use may be made of hydrochloric acid, sulfuric acid and organic acids, while the oxidizing agent may include chromic acid, chromate, permanganate, ozone and the like.

As the method of electroless plating, mention may be made of electroless copper plating, electroless nickel plating, electroless tin plating, electroless gold plating, electroless silver plating and the like. Among them, at least one of electroless copper plating, electroless nickel plating and electroless gold plating is preferable. Furthermore, different electroless plating or electrolytic plating or soldering may be applied to the above electroless plated film.

In the invention, the surface of the resin insulating layer is smooth, so that the thickness of the plating resist formed by applying the liquid plating resist is uniform and the resolution thereof is improved. Therefore, after the formation of the upper conductor circuit layer, the surface of this layer is further polished so as to render the surfaces of the plating resist and the upper conductor circuit layer into the same plane. Thus, the surface of the multilayer printed circuit board can be always smoothened even if the building-up of the conductor circuit layer through the additive process is repeated. In the building-up of the conductor circuit layer, therefore, it is possible to prevent the accumulation of unevenness. As a result, even if a fine part is attached to the multilayer printed circuit board, since the surface of the board is smooth, the terminals of the part can adequately be connected without floating and hence the mounting reliability can be improved. However, the smoothening through polishing is carried out only to the conductor circuit layer built up by the subtractive process but is not applied to the conductor circuit layer built up by the subsequent additive process, which is effective to reduce the production cost for the multilayer printed circuit board.

### (Example 1)

(1) 70 parts by weight of a 50% acrylated product of cresol novolac type epoxy resin (made by Nippon Kayaku Co., Ltd.), 30 parts by weight of bisphenol A-type epoxy resin (made by Yuka Shell Co., Ltd.), 5 parts by weight of benzophenone, 0.5 part by weight of Michlar ketone, 60 parts by weight of benzoguanamine filler (made by Nippon Shokubai Co., Ltd., trade name: Eposter, 0.5 µm) as an organic resin filler 10 hardly soluble in an imidazole curing agent and oxidizing agent are mixed and added with butylcellosolve acetate to adjust a viscosity to 30 pa·s in a homodisper agitating machine, which are further kneaded through three rolls to obtain an insulating material.
(2) 70 parts by weight of a 50% acrylated product of cresol novolac type epoxy resin (made by Nippon Kayaku Co., Ltd.), 30 parts by weight of bisphenol A-type epoxy resin (made by Yuka Shell Co., Ltd.), 5 parts by weight of benzophenone, 0.5 part by weight of Michlar ketone, 60 parts by weight of benzoguanamine filler (made by Nippon Shokubai Co., Ltd., trade name: Eposter, 0.5 µm) as an organic resin filler 10 hardly soluble in an imidazole curing agent and oxidizing agent are mixed and added with butylcellosolve acetate to adjust a viscosity to 30 pa·s in a homodisper agitating machine, which are further kneaded through three rolls to obtain an insulating material.
(2) 70 parts by weight of a 50% acrylated product of cresol novolac type epoxy resin (made by Nippon Kayaku Co., Ltd.), 30 parts by weight of bisphenol A-type epoxy resin (made by Yuka Shell Co., Ltd.), 5 parts by weight of benzophenone, 0.5 part by weight of Michlar ketone, 20 parts by weight at 5.5 µm and 10 parts by weight at 0.5 µm of epoxy resin filler (epoxy resin filler using an amine curing agent) as a heat-resistant resin particle 11 soluble in an imidazole curing agent and oxidizing agent are mixed and added with butylcellosolve acetate to adjust a viscosity to 30 pa·s in a homodisper agitating machine, which are further kneaded through three rolls to obtain an adhesive.
(3) The insulating material obtained in the above item (1) is applied onto a substrate 1 provided with a copper pattern formed by etching at a thickness of 40 µm by means of a roll coater, dried, exposed and developed to obtain an insulating layer 2 provided with an opening for blind viahole (BVH).
(4) The adhesive obtained in the above item (2) is applied onto the insulating layer 2 obtained in the above item (3) at a thickness of 20 µm by means of a roll coater, dried, exposed and developed to obtain an adhesive layer 3 provided with an opening for BVH having a size smaller than that of the opening for BVH of the insulating layer in the same position as the opening for BVH of the insulating layer. Then, the insulating layer 2 and the adhesive layer 3 are photocured and thermoset (photocuring: 3 J/cm², setting: 80°C x 1 hour + 100°C x 1 hour + 120°C x 1 hour + 150°C x 15 hours) to obtain a resin insulating layer provided with an opening 8 for BVH having a diameter of 70 µmφ.
(5) Then, the surface of the resin insulating layer is roughened according to usual manner using an oxidizing agent and thereafter Pd catalyst is applied onto the roughened surface of the resin insulating layer, which is heat-treated to fix a catalyst nucleus.
(6) Next, the substrate is preheated to 80°C and a plating resist 4 (dry film resist) is heat-pressed thereonto at 100°C, which is then exposed, developed, UV-cured and heat-treated in the usual manner to form a resist 4 printed with a given pattern. Moreover, 1,1,1-trichloroethane is used as a developing solution.
(7) After the catalyst is activated by an acid treatment, electroless plating is carried out by immersing in an electroless copper plating solution having a composition shown in Table 1 according to usual manner to form necessary conductor patterns 5, 6, 5', 6' and viahole (BVH) 9 (see Fig. 1(a)). Further, the steps on and after the above item (3) are repeated 2 times to produce a multilayer printed circuit board having 4 conductor layers.

In this example, the formations of the openings for BVH in the lower layer and the upper layer are carried out separately, but these formations may simultaneously be made. The latter case is as shown in Fig. 1(b).

**Table 1**

| | |
|---|---|
| Copper sulfate | 0.06 mol/l |
| Formalin (37%) | 0.30 mol/l |
| Sodium hydroxide | 0.35 mol/l |
| EDTA | 0.35 mol/l |
| Additive | slight |
| Plating temperature | 70-72°C |
| pH | 12.4 |

### (Example 2)

A multilayer printed circuit board is produced in the same manner as in Example 1 except that 50 parts by weight of styrene filler (made by Sumitomo Chemical Co., Ltd. trade name: Finepearl, 3 µm) is used as the organic resin filler 10 constituting the insulating layer and insoluble in the oxidizing agent and the thickness of the insulating layer 2 is 60 µm and the thickness of the adhesive layer is 20 µm.

### (example 3)

A multilayer printed circuit board is produced in the same manner as in Example 1 except that 80 parts by weight of divinylbenzene filler (made by Sekisui Fine Chemical Co., Ltd. trade name: Micropearl, 1.0 µm) is used as the organic resin filler 10 constituting the insulating layer and insoluble in the oxidizing agent and the thickness of the insulating layer 2 is 70 µm and the thickness of the adhesive layer is 10 µm.

### (Comparative Example 1)

A multilayer printed circuit board is produced in the same manner as in Example 1 except that the insulating material is not applied.

The interlaminar insulation resistance at a temperature of 85°C and a humidity of 85%, peel strength of electroless plated film (adhesion property) and heat cycle property at - 65°C x 10 minutes - 125°C x 10 minutes (resistance to cool-heat shock) are measured with respect to the thus produced multilayer printed circuit boards. The results are shown in Table 2.

As seen from the results of Table 2, it has been confirmed that all of the multilayer printed circuit boards exhibit excellent properties as compared with the comparative example in which the resin insulating layer is not constituted with the insulating layer 2 and adhesive layer 3 having different properties.

**Table 2**

| | Interlaminar insulation resistance (Ω)*1 | Peel strength (kg/cm) | Heat cycle property (cycle)*2 |
|---|---|---|---|
| Example | | | |
| 1 | 2.5x10¹⁴ | 1.8 | 1000 OK |
| 2 | 5.4x10¹⁴ | 1.8 | 1000 OK |
| 3 | 6.1x10¹⁴ | 1.8 | 1000 OK |

| Comparative Example | | | |
|---|---|---|---|
| 1 | 4.8x10⁶ | 1.8 | 1000 OK |

| | | | |
|---|---|---|---|
| *1: Interlaminar insulation resistance The insulation resistance is measured after a voltage of 24V is applied at a temperature of 85°C and a humidity of 85% for 1000 hours. *2: Heat cycle property A test of -65°C x 10 minutes ⇔ 125°C x 10 minutes is carried out to evaluate a durability level based on the presence or absence of cracking or the like. | | | |

### (Example 4)

(1) 70 parts by weight of a 25% acrylated product of cresol novolac type epoxy resin (made by Nippon Kayaku Co., Ltd.), 25 parts by weight of polyether sulphone (made by Mitsui Toatsu Co., Ltd.), 4 parts by weight of benzophenone, 0.4 part by weight of Michlar ketone and an imidazole curing agent are mixed and added with normalmethyl pyrolidone (NMP) to adjust a viscosity to 30 pa·s in a homodisper agitating machine, which are further kneaded through three rolls to obtain an insulating material.
(2) 70 parts by weight of a 25% acrylated product of cresol novolac type epoxy resin (made by Nippon Kayaku Co., Ltd.), 25 parts by weight of polyether sulphone (made by Mitsui Toatsu Co., Ltd.), 0.5 part by weight of Michlar ketone, an imidazole curing agent, 60 parts by weight at 5.5 µm and 15 parts by weight at 1.0 µm of melamine resin filler (made by Ibiden Co., Ltd.) as a heat-resistant resin particle 11 soluble in an acid and oxidizing agent are mixed and added with normalmethyl pyrolidone (NMP) to adjust a viscosity to 30 pa·s in a homodisper agitating machine, which are further kneaded through three rolls to obtain an adhesive.
(3) The insulating material obtained in the above item (1) is applied onto a substrate 1 provided with a copper pattern formed by etching at a thickness of 30 µm by means of a roll coater and dried, and thereafter the adhesive obtained in the above item (2) is applied thereonto at a thickness of 20 µm by means of a roll coater, dried, exposed, developed, photocured and thermoset to obtain a resin insulating layer provided with an opening 8 for BVH.
(4) Then, the surface of the resin insulating layer is roughened according to usual manner using permanganic acid-phosphoric acid and thereafter Pd catalyst is applied onto the roughened surface of the resin insulating layer, which is heat-treated to fix a catalyst nucleus.
(5) Next, a liquid plating resist is applied and then exposed, developed, photocured and thermoset to form a resist 4 printed with a given pattern.
(6) After the catalyst is activated by an acid treatment, electroless plating is carried out to form necessary conductor patterns 5, 6, 5', 6' and viahole (BVH) 9 (see Fig. 2(b)). Further, the steps on and after the above item (3) are repeated 2 times to produce a multilayer printed circuit board having 4 conductor layers.

Moreover, Fig. 2(a) is a case that the insulating layer and the adhesive layer are separately pierced to form openings 8 for BVH.

### (Example 5)

A multilayer printed circuit board is produced in the same manner as in Example 4 except that 20 parts by weight at 5.5 µm and 10 parts by weight at 0.5 µm of epoxy resin filler are mixed as a heat-resistant resin particle 11 constituting the adhesive and soluble in an acid and oxidizing agent.

### (Example 6)

A multilayer printed circuit board is produced in the same manner as in Example 4 except that the thickness of the insulating material applied to the substrate is 20 µm.

### Comparative Example 2

A multilayer printed circuit board is produced in the same manner as in Example 4 except that the insulating layer is not formed.

### (Comparative Example 3)

A multilayer printed circuit board is produced in the same manner as in Example 4 except that silica filler (made by Admatext, 0.5 µm) is mixed with the insulating material. In this case, the minimum opening size for BVH formable in the resin insulating layer is 70 µm, but the sidewall of BVH is tapered-form. This is due to the fact that the exposing light is turned beneath the mask through the diffused reflection of light by the silica filler.

The interlaminar insulation resistance at a temperature of 85°C and a humidity of 85%, peel strength of electroless plated film (adhesion property) and BVH resolution of resin insulating layer are measured with respect to the thus produced multilayer printed circuit boards. The results are shown in Table 3.

As seen from the results of this table, it has been confirmed that the multilayer printed circuit boards in which the resin insulating layer is constituted with the insulating layer 2 and the adhesive layer 3 having different properties, exhibit excellent properties as compared with the comparative example using one-layer structure as the resin insulating layer. Further, even if the thickness of the resin insulating layer is thin, the multilayer printed circuit board having an excellent interlaminar insulation resistance can be provided without lowering the peel strength.

**Table 3**

| | Interlaminar insulation resistance (Ω)*1 | Peel strength (kg/cm) | BVH resolution (µmφ)*2 |
|---|---|---|---|
| Example | | | |
| 4 | 3.2x10¹² | 2.0 | 80 |
| 5 | 2.4x10¹² | 2.1 | 100 |
| 6 | 8.0x10¹¹ | 2.0 | 70 |

| Comparative Example | | | |
|---|---|---|---|
| 2 | 1.3x10⁹ | 2.0 | 140 |
| 3 | 7.9x10¹¹ | 1.9 | 70 tapered |

| | | | |
|---|---|---|---|
| *1: Interlaminar insulation resistance The insulation resistance is measured after a voltage of 24V is applied at a temperature of 85°C and a humidity of 85% for 1000 hours. *2: BVH resolution A minimum opening size for BVH formable in the resin insulating layer is measured. | | | |

### (Example 7)

A multilayer printed circuit board is produced in the same manner as in Example 4 except that an insulating material formed by mixing 70 parts by weight of a 25% acrylated product of cresol novolac type epoxy resin (made by Nippon Kayaku Co., Ltd.), 5 parts by weight of benzophenone, 0.5 part by weight of Michlar ketone and an imidazole curing agent and adding normalmethyl pyrolidone (NMP) to adjust a viscosity to 30 Pa·a in a homodisper agitating machine and kneading through three rolls is used as the insulating material constituting the lower layer (insulating layer 2) of the resin insulating layer having a two-layer structure.

### (Example 8)

A multilayer printed circuit board is produced in the same manner as in Example 4 except that an insulating material formed by mixing 70 parts by weight of a 25% acrylated product of cresol novolac type epoxy resin (made by Nippon Kayaku Co., Ltd.), 30 parts by weight of bisphenol A-type epoxy resin (made by Yuka Shell Co., Ltd.), 5 parts by weight of benzophenone, 0.5 part by weight of Michlar ketone and an imidazole curing agent and adding normalmethyl pyrolidone (NMP) to adjust a viscosity to 30 Pa·s in a homodisper agitating machine and kneading through three rolls is used as the insulating material constituting the lower layer (insulating layer 2) of the resin insulating layer having a two-layer structure.

### (Example 9)

A multilayer printed circuit board is produced in the same manner as in Example 4 except that an insulating material formed by mixing 70 parts by weight of a 25% acrylated product of cresol novolac type epoxy resin (made by Nippon Kayaku Co., Ltd.), 30 parts by weight of phenol novolac type epoxy resin (made by Yuka Shell Co., Ltd.), 5 parts by weight of benzophenone, 0.5 part by weight of Michlar ketone and an imidazole curing agent and adding normalmethyl pyrolidone (NMP) to adjust a viscosity to 30 Pa·s in a homodisper agitating machine and kneading through three rolls is used as the insulating material constituting the lower layer (insulating layer 2) of the resin insulating layer having a two-layer structure.

The BVH resolution and interlaminar insulation resistance are measured with respect to the thus obtained printed circuit boards. As a result, the board of Example 7 has an interlaminar insulation resistance of 3.1x10¹² Ω and BVH resolution of 80 µm, and the board of Example 8 has an interlaminar insulation resistance of 3.0x10¹² Ω and BVH resolution of 80 µm, and the board of Example 9 has an interlaminar insulation resistance of 3.1x10¹² Ω and BVH resolution of 80 µm.

As seen from these results, all boards of Examples 7, 8 and 9 are excellent in the BVH resolution likewise the board of Example 4 because the organic resin filler is not included in the insulating material. However, when the heat cycle of - 65°C x 10 minutes ⇔ 125°C x 10 minutes is measured, as seen from the results shown in Table 4, the cracking is not caused in the board of Example 4 until 2000 cycles, while the cracking is caused at 1200 cycles in the board of Example 7, at 1200 cycles in the board of Example 8 and at 1200 cycles in the board of Example 9. This is considered to be due to the following facts: that is, in the board of Example 1, polyether sulphone (PES) as a thermoplastic resin is included in the insulating layer, so that the cracking hardly occurs due to the flexibility of the insulating layer. Particularly, the insulating layer of Example 4 is constituted with the resin composite of thermosetting resin and thermoplastic resin, so that it is excellent in the resistance to the oxidizing agent and the acid resistance. That is, the form of the board in Example 4 is excellent in all of BVH resolution, interlaminar insulation resistance and resistance to heat cycle (resistance to cool-heat shock).

### Example 10, embodiment of the present invention.

(1) A copper lined laminate plate formed by laminating copper foil 12 of 18 µm in thickness on both surfaces of a substrate 1 made from glass epoxy resin or BT (bismaleimide triazine) resin having a thickness of 1 mm is used as a starting material (see Fig. 3(a)). After the copper lined laminate plate is drilled and a plating resist is formed thereon, electroless plating is carried out to form a through-hole 13 and further conductor useless portions of the copper foil 12 are etched in form of a pattern to form innerlayer copper patterns 5, 5' on both surfaces of the substrate 1 (see Fig. 3(b)).
(2) 100 parts by weight of bisphenol F-type epoxy resin (made by Yuka Shell Co., Ltd. molecular weight: 172, trade name: E-807) is mixed with 6 parts by weight of an imidazole curing agent (made by Shikoku Kasei Co., Ltd. trade name: 2E4MZ-CN) and further the resulting mixture is mixed with 170 parts by weight of SiO₂ particles having an average particle size of 1.6 µm (the maximum size of the particulate is not more than 15 µm of the thickness of the following innerlayer copper pattern) and kneaded through three rolls to obtain a resin for the smoothening of the substrate having a viscosity of 100,000 cps (hereinafter referred to as a filling resin 14 simply).
(3) The filling resin 14 is printed at a thickness of 20 µm on one-side surface of the substrate provided with the innerlayer copper patterns 5, 5' in the above item (2) by means of a screen printing machine and the resulting resin layer is cured by subjecting to a heat treatment at 150°C for 30 minutes. The same resin layer is formed on the other side surface in the same manner as described above (see Fig. 3(c)). Moreover, the printing is carried out under conditions that a printing speed is 0.2 m/s and a printing pressure is 50 kg/cm² by using a screen printing plate of 200 mesh. If the filling resin 14 is heated at 150°C for 3 hours, it is substantially completely cured to be a high hardness. In this step, however, the resin is cured to a level capable of conducting belt sander polishing or buff polishing in order to facilitate the polishing operation of the filling resin.
(4) The one-side surface of the substrate provided with the resin layer in the above item (3) is polished with a belt polishing paper of #600 (made by Sankyo Rikagaku Co., Ltd.) in a belt sander so as not to leave the filling resin on the surface of the innerlayer copper pattern. Then, buff polishing is carried out for removing scratches created by the belt sander. Such a series of polishings are carried out on the other surface of the substrate likewise the above case. Then, the filling resin 14 filled in the through-holes 13 is completely crosslinked by heating at 150°C for 3 hours to obtain the substrate smoothened on both surfaces by the filling resin 14 (see Fig. 3(d)). Moreover, there can be adopted a method of carrying out belt sander polishing and subsequent buff polishing or a method of carrying out only the buff polishing so as to slightly leave the filling resin 14 on the surface of the innerlayer copper pattern.
(5) On the other hand, the insulating material is obtained by mixing 70 parts by weight of a 25% acrylated product of cresol novolac type epoxy resin (made by Nippon Kayaku Co., Ltd.), 25 parts by weight of polyether sulphone (made by Mitsui Toatsu Co., Ltd.), 4 parts by weight of benzophenone, 0.4 part by weight of Michlar ketone and an imidazole curing agent and adding normalmethyl pyrolidone (NMP) to adjust a viscosity to 30 Pa·s in a homodisper agitating machine and kneading them through three rolls.
(6) 70 parts by weight of a 25% acrylated product of cresol novolac type epoxy resin (made by Nippon Kayaku Co., Ltd. molecular weight: 2500). 30 parts by weight of polyether sulphone (made by Mitsui Toatsu Co., Ltd.), 5 parts by weight of benzophenone (made by Kanto Kagaku Co., Ltd.) as a photoinitiator, 0.4 part by weight of Michlar ketone as a photoinitiator, 4 parts by weight of an imidazole curing agent (made by Shikoku Kasei Co., Ltd. trade name: 2E4MZ-CN), 10 parts by weight of caprolactone-modified tris(acroxyethyl)isocyanurate (made by Toa Gosei Co., Ltd. trade name: Aronix M325) as a photosensitive monomer, 35 parts by weight at 5.5 µm and 5 parts by weight at 0.5 µm of epoxy resin filler (made by Toray Co., Ltd. trade name: Torepearl) as a heat-resistant resin particle 11 soluble in acid or oxidizing agent are mixed and added with normalmethyl pyrolidone (NMP) to adjust a viscosity to 2000 cps in a homodisper agitating machine and further kneaded through three rolls to obtain a photosensitive adhesive. The photosensitive adhesive is formed by dispersing the heat-resistant resin particles 11 soluble in a roughening solution such as chromic acid, phosphoric acid or the like into the resin matrix hardly soluble in the roughening solution.
(7) The insulating material obtained in the item (5) is applied onto both surfaces of the substrate smoothened in the item (4) by means of a roll coater and left at a horizontal state for 20 minutes and dried at 60°C (prebaked) to form an insulating layer 2 (see Fig. 3(e)).
Further, the photosensitive adhesive obtained in the item (6) is applied onto the insulating layer 2 by means of a roll coater, left at a horizontal state for 20 minutes and dried at 60°C (prebaked) to form an adhesive layer 3 (see Fig. 3(f)).
(8) A polyethylene terephthalate (PET) film provided on a back surface with a tackifier is stuck on both surfaces of the substrate provided with the insulating layer 2 and the adhesive layer 3 in the item (7) to shut off contacting with oxygen obstructing the polymerization reaction. Then, a photomask film printed with viaholes is placed thereonto, which is exposed to a light from a superhigh pressure mercury lamp of 400 mJ/cm². After the photomask film is taken out, the substrate is exposed to a light from a superhigh pressure mercury lamp of about 3000 mJ/cm². After the peeling of the PET film, the substrate is developed with triethylene glycol dimethylether (DMTG). Thereafter, heat treatment is carried out at 150°C for 5 hours (postbaked) to form a resin insulating layer (two-layer structure) of 50 µm provided with an opening (opening for the formation of viahole) 8 having an excellent size accuracy corresponding to the photomask film (see Fig. 3(g)).
(9) The surface of the resin insulating layer is roughened by using a roughening solution such as chromic acid, potassium permanganate or the like according to usual manner. Concretely, the substrate provided with the resin insulating layer is immersed in chromic acid at 70°C for 20 minutes to dissolve and remove the heat-resistant resin particles dispersed in the surface of the adhesive layer constituting the resin insulating layer, whereby the roughened surface provided with many fine anchors is formed on the surface of the adhesive layer.
(10) A catalyst nucleus required for initial precipitation of electroless plating metal is given to the surface of the resin insulating layer roughened in the item (9) by treating in a solution of PdCl₂·2H₂O: 0.2 g/l, SnCl₂·2H₂O: 15 g/l, HCl: 30 g/l, and then a commercially available liquid photoresist is applied to the surface of the resin insulating layer at a thickness of 60 µm, dried and subjected to light exposure and development to form a plating resist 4 (line width 50 µm).
(11) After the catalyst nucleus is activated by treating with an aqueous solution of 100 g/l sulfuric acid, a primary plating is carried out by using an electroless copper-nickel alloy plating bath having the following composition to form a copper-nickel-phosphorus plated thin film having a thickness of about 1.7 µm on the non-resist formed portion. In this case, the temperature of the plating bath is 60°C and the plating immersion time is 1 hour.

| | | |
|---|---|---|
| Metal salt | CuSO₄·5H₂O | : 6.0 mM (1.5 g/l) |
| | NiSO₄·6H₂O | : 95.1 mM (25 g/l) |
| Complexing agent | Na₂C₆H₅O₇ | : 0.23 M (60 g/l) |
| Reducing agent | NaPH₂O₂·H₂O | : 0.19 M (20 g/l) |
| pH adjusting agent | NaOH | : 0.75 M (pH = 9.5) |
| Stabilizer | lead nitrate | : 0.2 mM (80 ppm) |
| Surfactant | | : 0.05 g/l |
| Precipitation rate | | : 1.7 µm/hr |

(12) The substrate subjected to the primary plating treatment is taken out from the plating bath and washed with water to remove the plating solution remained on the surface thereof, which is treated with an acidic solution to remove oxide film from the surface layer of the copper-nickel-phosphorus thin film. Thereafter, the copper-nickel-phosphorus plated thin film is subjected to a secondary plating by using an electroless copper plating bath having the following composition without conducting Pd substitution, whereby necessary conductor patterns 6, 6' and viahole (BVH) 9 are formed (see Fig. 3(h)). In this case, the temperature of the plating bath is 50°C-70°C and the plating immersion time is 90 minutes-360 minutes.

| | | |
|---|---|---|
| Metal salt | CuSO₄·5H₂O | : 8.6 mM |
| Complexing agent | TEA | : 0.15 M |
| Reducing agent | HCHO | : 0.02 M |
| Others | stabilizer (bipyridyl, potassium ferrocyanide and the like): small | |
| Precipitation rate | | : 6 µm/hr |

(13) Both surfaces of the substrate provided with the conductor patterns 6, 6' and viahole (BVH) 9 in the items (11) (12) are polished with a #600 belt polishing pater in a belt sander and further buff-polished. In this case, the polishing is carried out so as to align the surface of the plating resist 4 with the surface of the conductor layer 6, 6' at the same plane.
(14) The steps of the items (7)-(13) are repeated to produce a multilayer printed circuit board having 6 layers on each surface (see Fig. 3(i)).

The interlaminar insulation resistance, BVH resolution and heat cycle property are evaluated under the conditions as mentioned above with respect to the thus obtained multilayer printed circuit board. As a result, the interlaminar insulation resistance is 3.1x10¹² Ω, and the BVH resolution is 80 µm, and the cracking is not created until 2000 times in the heat cycle test.

Further, when PCT (pressure cooker test) test is carried out together with the multilayer printed circuit board obtained in Example 4 as a comparative material, the peeling between the adhesive layer and the insulating layer is not observed in the board of this example. However, in the board of Example 1, there is observed a slight peeling (swelling) between the adhesive layer and the insulating layer. Although the reason is not clear, it is presumed that the board of Example 4 not filled with the filling resin in the concave portion between the conductor circuits has no problem under usual use conditions but when it is placed under conditions of high temperature and high humidity as in the PCT test, since the boundary between the adhesive layer and the insulating layer is uneven, the resin expands due to thermal expansion and water absorption and hence stress concentrates in the uneven portion to cause the peeling.

Moreover, the PCT test is carried out by leaving the specimen to stand under conditions of 2 atmospheric pressure, temperature of 121°C and humidity of 100% for 200 hours.

### (Example 11)

In the item (5) of Example 10, 30 parts by weight of epoxy resin particles (made by Toray Co., Ltd. trade name: Torepearl) having an average particle size of 0.3-0.5 µm are compounded into the insulating material as a heat-resistant resin particle 11 soluble in acid or oxidizing agent. Further, the development of the interlaminar insulating material (adhesive and insulating material) is carried out by adopting a method of spraying to a vertically stood substrate (which means that normal vector of the substrate is perpendicular to vector of gravity). Thus, the multilayer printed circuit board is produced in the same manner a in Example 10.

The interlaminar insulation resistance, BVH resolution and heat cycle property are measured with respect to the thus obtained multilayer printed circuit board. As a result, the interlaminar insulation resistance is 3.2x10¹² Ω, and the BVH resolution is 90 µm, and the cracking is not created until 2000 times in the heat cycle test. Further, the peeling is not observed when the PCT test is carried out in the same manner as in Example 9.

In Example 11, the development residue is not observed though the spray development method is adopted while vertically standing the substrate.

The method of spraying the developing solution while vertically standing the substrate is very efficient in the production of both-side multilayer printed circuit board, and also the product is not affected by gravity and there is caused no difference in the properties between the front and back surfaces. Inversely, there may be slightly caused the occurrence of development residue in accordance with the intensity of the spraying and the hitting of the developing solution, but it is considered that slight development residue may be removed at the roughening step in the substrate of Example 11.

**Table 4**

| Example | 4 | 7 | 8 | 9 | 10 | 11 |
|---|---|---|---|---|---|---|
| Heat cycle | 2000 times OK | 1200 times crack | 1200 times crack | 1200 times crack | 2000 times OK | 2000 times OK |
| BVH resolution | 80 µm | 80 µm | 80 µm | 80 µm | 80 µm | 90 µm |
| Interlaminar insulation resistance (x 10¹² Ω) | 3.2 | 3.1 | 3.0 | 3.1 | 3.1 | 3.2 |
| PCT test | peel | - | - | - | no peel | no peel |

### INDUSTRIAL APPLICABILITY

As mentioned above, according to the invention, even when the innermost layer of the conductor circuit is formed by the etching treatment through the subtractive process, there is no unevenness on the surface, and also even if the thickness of the resin insulating layer is thin, the peel strength is not lowered, whereby there can stably be provided the multilayer printed circuit boards having excellent resolution, interlaminar insulation property and resistance to cool-heat shock.

Therefore, the multilayer printed circuit board according to the invention exhibits excellent adaptability in many fields requiring high performance and densification of electronic parts.

## Claims

1. A multilayer printed circuit board comprising:
a substrate (1) having a plated through-hole (13) therein;
a lower conductor circuit layer (5) formed on the substrate by etching the substrate (1) provided with a conductor layer to remove a conductor useless portion therefrom to thereby include a conductor circuit pattern portion and a conductor removed portion;
a resin insulating layer (2) formed on the lower conductor circuit layer (5) wherein said resin insulating layer is comprised of a composite layer (2,3) consisting of an insulating layer (2) made from a heat-resistant resin hardly soluble in acid or an oxidizing agent as a lower layer and an adhesive layer (3) for electroless plating made from a heat-resistant resin as an upper layer; and
an upper conductor circuit layer (6) formed on the resin insulation layer,
**characterized by comprising:**
a filling resin (14) filled in a concave portion defined by the conductor removed portion and filled in the plated through-hole so that the surface of the filling resin (14) is at the same level as the surface of the lower conductor circuit layer (5) wherein the filling resin (14) contains ceramic particles.

2. A multilayer printed circuit board according to claim 1, wherein the resin filled in the concave portion defined by the conductor removed portion is a cured product of non-solvent resin.

3. A multilayer printed circuit board according to claim 1, wherein particles of a heat-resistant resin soluble in the acid or oxidizing agent and having an average particle size of 0.1-0.6 µm are dispersed in the insulating layer made from the heat-resistant resin hardly soluble in acid or oxidizing agent.

4. A multilayer printed circuit board according to any one of the claims 1 to 3, wherein said lower conductor circuit layer and said upper conductor circuit layer is electrically connected to each other through a via hole (9) formed in the resin insulating layer.

5. A multilayer printed circuit board according to any one of the claims 1 to 4, wherein said resin insulating layer is comprised of a composite layer of thermosetting resin and thermoplastic resin.

6. A method of producing a multilayer printed circuit board comprising a substrate (1) having a plated through-hole (13) therein, a lower conductor circuit layer (5) formed on the substrate, a resin insulating layer (2) formed on the lower conductor circuit layer (5), and an upper conductor circuit layer (6) formed on said resin insulating layer which comprises the following steps (a) - (e):
(a) a step of forming said lower conductor circuit layer by etching the substrate provided with a conductor layer to remove a conductor useless portion therefrom to form a conductor circuit pattern portion and a conductor removed portion, and forming the plated through-hole in the substrate;
(b) a step of applying a filling resin (14) containing ceramic particles to the substrate to fill the plated through-hole and a concave portion defined by the conductor removed portion and then curing the resin;
(c) a step of polishing the cured resin of the step (b) till the lower conductor circuit layer is exposed;
(d) a step of forming said resin insulating layer wherein said resin insulating layer is a composite layer consisting of an insulating layer made from a heat-resistant resin hardly soluble in acid or an oxidizing agent as a lower layer and an adhesive layer for electroless plating made from a heat-resistant resin as an upper layer.
(e) a step of forming said upper conductor circuit layer on said adhesive layer.

7. A method of producing a multilayer printed circuit board according to claim 6, wherein particles of a heat-resistant resin soluble in the acid or oxidizing agent and having an average particle size of 0.1-0.6 µm are dispersed in the insulating layer made from the heat-resistant resin hardly soluble in acid or oxidizing agent.

## Patentansprüche

1. Mehrschichtige Leiterplatte, die umfasst:
ein Substrat (1) mit einem plattierten Durchgangsloch (13) darin;
eine untere Leiter-Schaltungsschicht (5), die auf dem Substrat ausgebildet wird, indem das mit einer Leiterschicht versehene Substrat (1) geätzt wird, um einen unnötigen Leiterabschnitt daraus zu entfernen, so dass sie einen Leiterschaltungs-Musterabschnitt und einen Abschnitt enthält, aus dem der Leiter entfernt ist;
eine Harz-Isolierschicht (2), die auf der unteren Leiter-Schaltungsschicht (5) ausgebildet ist, wobei die Harz-Isolierschicht aus einer Verbundschicht (2, 3) besteht, die sich aus einer Isolierschicht (2), die aus einem wärmebeständigen Harz besteht, das in Säure oder einem Oxidationsmittel kaum löslich ist, als einer unteren Schicht und einer Klebeschicht (3) zum stromlosen Plattieren, die aus einem wärmebeständigen Harz besteht, als einer oberen Schicht zusammensetzt; und
eine obere Leiter-Schaltungsschicht (6), die auf der Harz-Isolierschicht ausgebildet ist,
**dadurch gekennzeichnet, dass** sie umfasst:
ein Füllharz (14), das in einen konkaven Abschnitt gefüllt ist, der durch den Abschnitt gebildet wird, in dem der Leiter entfernt ist, und in das plattierte Durchgangsloch gefüllt ist, so dass sich die Oberfläche des Füllharzes (14) auf der gleichen Höhe befindet wie die Oberfläche der unteren Leiter-Schaltungsschicht (5), wobei das Füllharz (14) Keramikteilchen enthält.

2. Mehrschichtige Leiterplatte nach Anspruch 1, wobei das Harz, das in den konkaven Abschnitt gefüllt ist, der durch den Abschnitt gebildet wird, in dem der Leiter entfernt ist, ein ausgehärtetes Erzeugnis aus nicht lösbarem Harz ist.

3. Mehrschichtige Leiterplatte nach Anspruch 1, wobei Teilchen aus einem wärmebeständigen Harz, das in der Säure oder dem Oxidationsmittel löslich ist, die eine durchschnittliche Teilchengröße von 0,1-0,6 µm haben, in der Isolierschicht dispergiert sind, die aus dem wärmebeständigen Harz besteht, das in Säure oder Oxidationsmittel kaum löslich ist.

4. Mehrschichtige Leiterplatte nach einem der Ansprüche 1 bis 3, wobei die untere Leiter-Schaltungsschicht und die obere Leiter-Schaltungsschicht über ein Kontaktloch (9) miteinander verbunden sind, das in der Harz-Isolierschicht ausgebildet ist.

5. Mehrschichtige Leiterplatte nach einem der Ansprüche 1 bis 4, wobei die Harz-Isolierschicht aus einer Verbundschicht aus wärmehärtendem Harz und Thermoplastharz besteht.

6. Verfahren zum Herstellen einer mehrschichtigen Leiterplatte, die ein Substrat (1) mit einem plattierten Durchgangsloch (13) darin, eine untere Leiter-Schaltungsschicht (5), die auf dem Substrat ausgebildet ist, eine Harz-Isolierschicht (2), die auf der unteren Leiter-Schaltungsschicht (5) ausgebildet ist, und eine obere Leiter-Schaltungsschicht (6) umfasst, die auf der Harz-Isolierschicht ausgebildet ist, wobei das Verfahren die folgenden Schritte (a)-(e) umfasst:
(a) einen Schritt des Ausbildens der unteren Leiterschaltungsschicht durch Ätzen des mit einer Leiterschicht versehenen Substrats, um einen unnötigen Leiterabschnitt daraus zu entfernen und einen Leiterschaltungs-Musterabschnitt sowie einen Abschnitt auszubilden, in dem der Leiter entfernt ist, und des Ausbildens des plattierten Durchgangslochs in dem Substrat;
(b) einen Schritt des Aufbringens eines Füllharzes (14), das Keramikteilchen enthält, auf das Substrat, um das plattierte Durchgangsloch und einen konkaven Abschnitt auszufüllen, der durch den Abschnitt gebildet wird, in dem der Leiter entfernt ist, und des anschließenden Aushärtens des Harzes;
(c) einen Schritt des Polierens des in dem Schritt (b) ausgehärteten Harzes, bis die untere Leiter-Schaltungsschicht freigelegt ist;
(d) einen Schritt des Ausbildens der Harz-Isolierschicht, wobei die Harz-Isolierschicht eine Verbundschicht ist, sich aus einer Isolierschicht, die aus einem wärmebeständigen Harz besteht, das in Säure oder einem Oxidationsmittel kaum löslich ist, als einer unteren Schicht und einer Klebeschicht zum stromlosen Plattieren, die aus einem wärmebeständigen Harz besteht, als einer oberen Schicht zusammensetzt;
(e) einen Schritt des Ausbildens der oberen Leiter-Schaltungsschicht auf der Klebeschicht.

7. Verfahren zum Herstellen einer mehrschichtigen Leiterplatte nach Anspruch 6, wobei Teilchen aus einem wärmebeständigen Harz, das in der Säure oder dem Oxidationsmittel löslich ist, die eine durchschnittliche Teilchengröße von 0,1-0,6 µm haben, in der Isolierschicht dispergiert sind, die aus dem wärmebeständigen Harz besteht, das in Säure oder Oxidationsmittel kaum löslich ist.

## Revendications

1. Carte de circuit imprimé multicouche comprenant :
un substrat (1) comportant un trou traversant plaqué (13) ;
une couche conductrice de circuit inférieure (5) formée sur le substrat par gravure du substrat (1) doté d'une couche conductrice pour éliminer de celle-ci une partie conductrice inutile pour comprendre ainsi une partie conductrice de motif du circuit et une partie conductrice éliminée ;
une couche isolante de résine (2) formée sur la couche conductrice de circuit inférieure (5) dans laquelle ladite couche isolante de résine est composée d'une couche composite (2, 3) constituée d'une couche isolante (2) faite d'une résine thermorésistante difficilement soluble dans de l'acide ou un agent d'oxydation en tant que couche inférieure et d'une couche adhésive (3) pour un plaquage anélectrolytique faite d'une résine thermorésistante en tant que couche supérieure ; et
une couche conductrice de circuit supérieure (6) formée sur la couche isolante de résine,
**caractérisée en ce qu'elle comprend :**
une résine de remplissage (14) remplie dans une partie concave définie par la partie conductrice éliminée et remplie dans le trou traversant plaqué de sorte que la surface de la résine de remplissage (14) est au même niveau que la surface de la couche conductrice de circuit inférieure (5) dans laquelle la résine de remplissage (14) contient des particules de céramique.

2. Carte de circuit imprimé multicouche selon la revendication 1, dans laquelle la résine remplie dans la partie concave définie par la partie conductrice éliminée est un produit durci de résine sans solvant.

3. Carte de circuit imprimé multicouche selon la revendication 1, dans laquelle des particules d'une résine thermorésistante soluble dans l'acide ou l'agent d'oxydation et ayant une taille moyenne de particule de 0,1 à 0,6 µm sont dispersées dans la couche isolante faite de la résine thermorésistante difficilement soluble dans l'acide ou l'agent d'oxydation.

4. Carte de circuit imprimé multicouche selon l'une quelconque des revendications 1 à 3, dans laquelle ladite couche conductrice de circuit inférieure et ladite couche conductrice de circuit supérieure sont électriquement connectées l'une à l'autre à travers un trou d'interconnexion (9) formé dans la couche isolante de résine.

5. Carte de circuit imprimé multicouche selon l'une quelconque des revendications 1 à 4, dans laquelle ladite couche isolante de résine est composée d'une couche composite de résine thermodurcissable et de résine thermoplastique.

6. Procédé de production d'une carte de circuit imprimé multicouche comprenant un substrat (1) comportant un trou traversant plaqué (13), une couche conductrice de circuit inférieure (5) formée sur le substrat, une couche isolante de résine (2) formée sur la couche conductrice de circuit inférieure (5), et une couche conductrice de circuit supérieure (6) formée sur ladite couche isolante de résine, qui comprend les étapes (a) à (e) suivantes :
(a) une étape de formation de ladite couche conductrice de circuit inférieure par gravure du substrat doté d'une couche conductrice pour éliminer de celle-ci une partie conductrice inutile pour former une partie conductrice de motif du circuit et une partie conductrice éliminée, et de formation du trou traversant plaqué dans le substrat ;
(b) une étape d'application d'une résine de remplissage (14) contenant des particules de céramique sur le substrat pour remplir le trou traversant plaqué et une partie concave définie par la partie conductrice éliminée, puis de durcissement de la résine ;
(c) une étape de polissage de la résine durcie de l'étape (b) jusqu'à ce que la couche conductrice de circuit inférieure soit exposée ;
(d) une étape de formation de ladite couche isolante de résine dans laquelle ladite couche isolante de résine est une couche composite constituée d'une couche isolante faite d'une résine thermorésistante difficilement soluble dans de l'acide ou un agent d'oxydation en tant que couche inférieure et d'une couche adhésive pour un plaquage anélectrolytique faite d'une résine thermorésistante en tant que couche supérieure ;
(e) une étape de formation de ladite couche conductrice de circuit supérieure sur ladite couche adhésive.

7. Procédé de production d'une carte de circuit imprimé multicouche selon la revendication 6, dans lequel des particules d'une résine thermorésistante soluble dans l'acide ou l'agent d'oxydation et ayant une taille moyenne de particule de 0,1 à 0,6 µm sont dispersées dans la couche isolante faite de la résine thermorésistante difficilement soluble dans l'acide ou l'agent d'oxydation.
